# FASCICULE DE BREVET EUROPEEN

(11) **EP 3 001 201 B1**
(45) Date de publication et mention de la délivrance du brevet: **01.08.2018**
(21) Numéro de dépôt: 15186983.1
(22) Date de dépôt: 25.09.2015
(51) Int. Cl.: G01P 3/487

(54) **DISPOSITIF DE MESURE DE VITESSE DE ROTATION D'UNE ROUE**
DREHGESCHWINDIGKEITS-MESSVORRICHTUNG FÜR RAD
DEVICE FOR MEASURING THE ROTATIONAL SPEED OF A WHEEL

(30) Priorité: 26.09.2014 FR 1459138
(43) Date de publication de la demande: 30.03.2016
(73) Titulaire: Safran Landing Systems, 78140 Vélizy-Villacoublay (FR)
(72) Inventeur: ZABULON, Joël, 78140 VELIZY-VILLACOUBLAY (FR); FRANK, David, 78140 VELIZY-VILLACOUBLAY (FR)
(74) Mandataire: Parzy, Benjamin Alain

(56) Documents cités:
- WO-A1-2013/076214
- DE-A1-102010 039 532
- US-A1- 2005 174 001
- US-A1- 2011 018 526
- US-A1- 2011 068 912
- US-A1- 2011 140 645

## Description

L'invention concerne un dispositif de mesure de vitesse de rotation d'une roue de véhicule. Le dispositif comprend un rotor, un stator, et une carte électronique alimentée par une tension générée aux bornes du stator par la rotation du rotor.

### ARRIERE PLAN DE L'INVENTION

Les systèmes avioniques des aéronefs modernes sont de moins en moins « centralisés » et de plus en plus « distribués ».

On remplace ainsi des architectures centralisées comportant un calculateur central, relativement complexe, connecté par de multiples câbles électriques à des actionneurs qu'il pilote ou à des capteurs lui fournissant des données de mesure, par des architectures distribuées comprenant un certain nombre de calculateurs « distants » situés à proximité des actionneurs et des capteurs. Ces calculateurs distants sont éventuellement reliés à un calculateur « coeur » dédié aux calculs.

L'éclatement du calculateur central en une pluralité de calculateurs distants permet de réduire la masse de l'aéronef grâce à la simplification du câblage, et de réduire le coût des systèmes avioniques, notamment grâce au fait que les calculateurs distants et le calculateur coeur sont désormais conçus pour être des calculateurs génériques pouvant être intégrés dans différents systèmes. Cet éclatement permet aussi d'améliorer la disponibilité des systèmes qui peuvent fonctionner en mode dégradé et qui présentent des possibilités de reconfiguration plus nombreuses en cas de panne d'un calculateur distant, d'un actionneur ou d'un capteur.

Un certain nombre d'architectures ont été proposées pour distribuer le système de freinage des roues de l'aéronef et le système de surveillance des paramètres de fonctionnement du train d'atterrissage.

La mise en oeuvre de la fonction d'anti-patinage du système de freinage nécessite de mesurer la vitesse de rotation des roues freinées. Le système de surveillance, quant à lui, effectue des mesures de la température des freins, de la pression des pneumatiques, etc.

L'ensemble de ces mesures subissent des opérations de traitement qui sont pour la plupart réalisées par des calculateurs ou concentrateurs de données associés à une pluralité de roues et situés dans l'aéronef à une certaine distance des roues. La distribution de ces architectures n'est donc pas optimisée. Pour bénéficier pleinement des avantages des architectures distribuées évoquées plus tôt, il convient de tenter de réaliser le maximum d'opérations de traitement à proximité des roues, en veillant toutefois à ce que la mise en oeuvre de ces opérations de traitement ne s'accompagne pas d'une augmentation du nombre de câbles cheminant sur les atterrisseurs.

### OBJET DE L'INVENTION

L'invention a pour objet d'améliorer la distribution des architectures du système de freinage des roues de l'aéronef et du système de surveillance des paramètres de fonctionnement du train d'atterrissage, sans pour autant augmenter le nombre de câbles cheminant sur les atterrisseurs.

### RESUME DE L'INVENTION

En vue de la réalisation de ce but, on propose un dispositif de mesure de la vitesse de rotation d'une roue de véhicule. Le dispositif de mesure comporte un corps dans lequel sont intégrés :
- un rotor pouvant être entraîné en rotation par la roue et sur lequel est monté au moins un aimant permanent ;
- un stator comportant un bobinage générant une tension de mesure lorsque la roue et donc l'aimant permanent tournent, la tension de mesure étant représentative de la vitesse de rotation de la roue ;
- une carte électronique comportant des moyens de traitement de la tension de mesure ;
- des moyens d'alimentation adaptés à générer à partir de la tension de mesure une tension d'alimentation destinée à alimenter la carte électronique.

Ainsi, les opérations de traitement sur la tension de mesure sont réalisées par la carte électronique qui est directement intégrée au corps du dispositif de mesure de la vitesse de rotation de la roue. On améliorer ainsi la distribution de l'architecture du système de freinage des roues de l'aéronef. On note par ailleurs que la carte électronique peut aussi réaliser des opérations de traitement d'autres mesures réalisées par le système de surveillance de paramètres de fonctionnement du train d'atterrissage, ou bien alimenter les capteurs utilisés pour réaliser ces autres mesures. L'architecture du système de surveillance est ainsi elle aussi mieux distribuée. Comme la carte électronique est alimentée directement à partir de la tension de mesure, il n'est pas nécessaire de prévoir un câble cheminant sur l'atterrisseur et destiné à transporter une énergie électrique d'alimentation. Chaque dispositif de mesure de la vitesse de rotation d'une roue est donc relié au reste de l'aéronef par un unique câble transportant des données, comme c'est le cas pour les dispositifs de mesure traditionnels.

### BREVE DESCRIPTION DES DESSINS

L'invention sera mieux comprise à la lumière de la description qui suit en référence aux figures des dessins annexés parmi lesquelles :
- la figure 1 représente une vue de face d'un atterrisseur portant une roue vue en coupe, ladite roue étant munie du dispositif de mesure de l'invention ;
- la figure 2 représente l'architecture d'une carte électronique du dispositif de mesure de l'invention ;
- la figure 3 représente des premiers moyens d'adaptation de la carte électronique ;
- la figure 4 représente des deuxièmes moyens d'adaptation de la carte électronique.

### DESCRIPTION DETAILLEE DE L'INVENTION

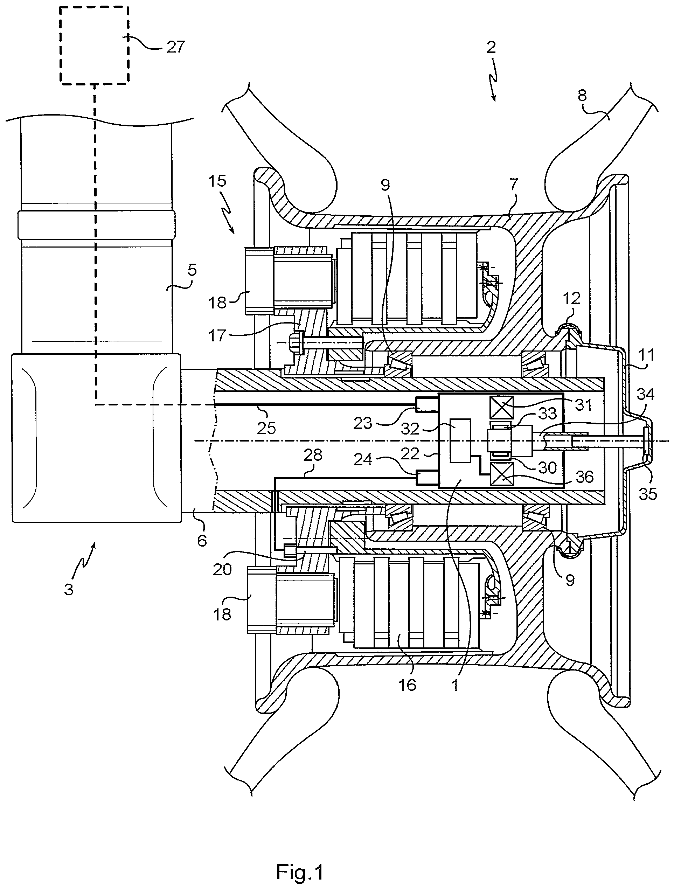

En référence à la figure 1, le dispositif de mesure de l'invention 1 est ici destiné à mesurer la vitesse de rotation d'une roue 2 d'un atterrisseur d'aéronef 3.

L'atterrisseur 3 comporte de manière classique un caisson articulé à la structure de l'aéronef dans lequel une tige coulissante 5 est montée à coulissement télescopique. La tige coulissante 5 porte à son extrémité un essieu 6 destiné à recevoir la roue 2.

La roue 2 comporte une jante 7 qui porte un pneumatique 8 et qui est montée pour tourner sur l'essieu 6 au moyen de roulements coniques 9. Un capot de roue 11, destiné à protéger l'intérieur de l'essieu 6, est fixé sur la jante au moyen d'un collier de serrage 12.

La roue 2 est en outre équipée d'un frein 15 adapté à freiner la roue 2, le frein 15 comportant une pile de disques de carbone 16 s'étendant dans la jante 7 de la roue 2, une couronne 17 fixée sur l'essieu 6, et une pluralité d'actionneurs électromécaniques 18 portés par la couronne 17 et adaptés à appliquer sélectivement un effort de freinage sur la pile de disques 16.

Le frein 15 comporte un capteur de température 20 destiné à mesurer la température régnant à l'intérieur de la pile de disques 16 (ou, plus exactement, à proximité de la pile de disques 16). Ce capteur de température 20 s'étend à l'intérieur d'une cavité du frein parallèlement à l'essieu 6 et à proximité de la pile de disques 16.

Le dispositif de mesure 1, quant à lui, comporte un corps 22 muni d'un premier connecteur 23 et d'un deuxième connecteur 24. Le corps 22 est disposé à l'intérieur de l'essieu 6 et est fixé à l'essieu 6 par des moyens classiques de fixation non représentés ici.

Le dispositif de mesure 1 est connecté par un premier câble 25 via le premier connecteur 23 à une unité de contrôle 27 située dans la soute de l'aéronef et par un deuxième câble 28 via le deuxième connecteur 24 au capteur de température 20 du frein 15.

Le dispositif de mesure 1 comporte en outre un rotor 30, un stator 31 et une carte électronique 32 qui sont intégrés à l'intérieur du corps 22 du dispositif de mesure 1.

Le rotor 30 comporte ici au moins un aimant permanent, en l'occurrence une pluralité d'aimants permanents 33. Le rotor 30 est solidaire d'une première extrémité d'une tige 34 dont une deuxième extrémité coopère avec un embout 35 fixé à une face interne du capot 11, de sorte que la tige 34 est solidaire en rotation du capot 11 et donc de la jante 7 de la roue 6.

Le stator 31 comporte un bobinage triphasé 36 situé à proximité immédiate du rotor.

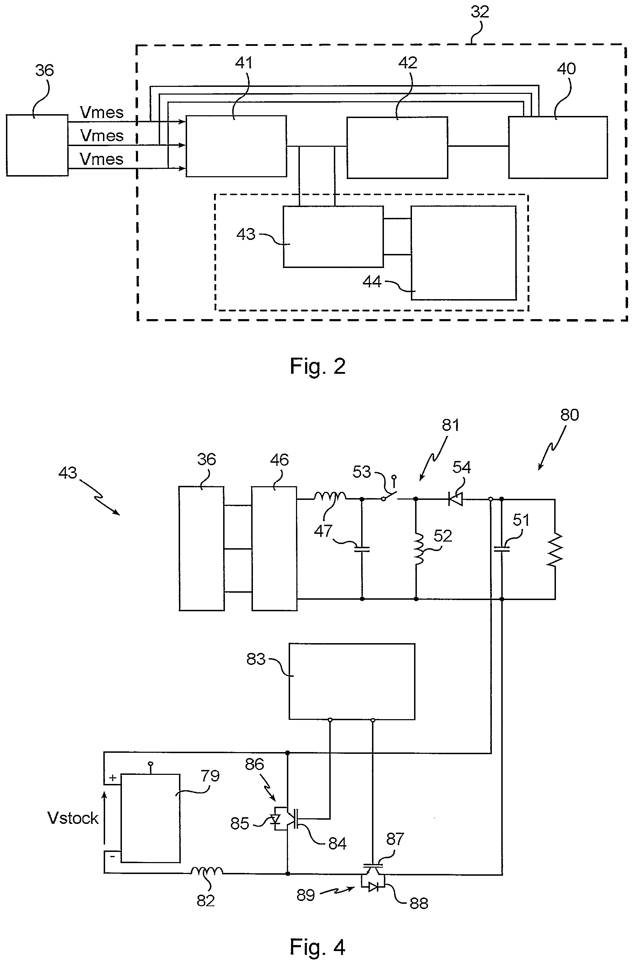

En référence à la figure 2, le bobinage 36 génère une tension de mesure triphasée Vmes lorsque la roue 2 et donc les aimants permanents 33 du rotor 30 tournent. La fréquence de la tension de mesure Vmes est directement proportionnelle à la vitesse de rotation de la roue 2 et est utilisée pour obtenir la vitesse de rotation de la roue.

La carte électronique 32, quant à elle, comporte un certain nombre de composants électroniques parmi lesquels des moyens de traitement 40, des moyens d'alimentation 41, des premiers moyens d'adaptation 42, des deuxièmes moyens d'adaptation 43 et des moyens de stockage d'énergie 44.

Les moyens de traitement 40 sont ici destinés à acquérir la fréquence de la tension de mesure Vmes, à la numériser, et à la transformer en une information de vitesse de rotation de la roue 2. Les moyens de traitement 40 sont de plus adaptés à recevoir une information de mesure de la température du frein 15 via le deuxième connecteur 24 et le deuxième câble 28. Les moyens de traitement 40 sont en outre adaptés à transmettre l'information de vitesse de rotation de la roue 2 et l'information de température du frein 15 à l'unité de contrôle 27 via le premier connecteur 23 et le premier câble 25.

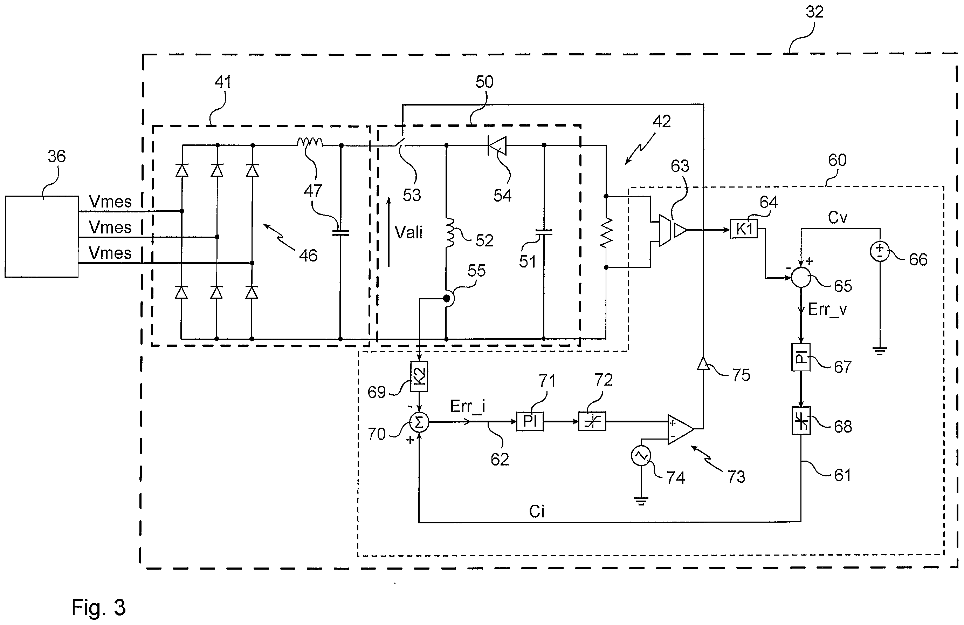

En référence à la figure 3, les moyens d'alimentation 41 comportent ici un redresseur triphasé 46 et des composants de lissage de tension et de courant 47. Les moyens d'alimentation 41 génèrent à partir de la tension de mesure Vmes une tension d'alimentation continue Vali destinée à alimenter les composants électroniques de la carte électronique 32 ainsi que le capteur de température 20 du frein 15 via le deuxième connecteur 24 et le deuxième câble 28.

La tension d'alimentation Vali dépend de l'amplitude et de la fréquence de la tension de mesure Vmes, qui dépendent quant à elles principalement de la vitesse de rotation de la roue 2: plus la vitesse de rotation de la roue 2 est élevée, plus la tension d'alimentation Vali est importante.

Les premiers moyens d'adaptation 42 sont destinés à abaisser la tension d'alimentation Vali lorsque celle-ci est supérieure à un premier seuil de tension prédéterminé et à relever la tension d'alimentation lorsque celle-ci est inférieure au premier seuil de tension prédéterminé.

Le premier seuil de tension prédéterminé est ici égal à 5 volts. On fournit ainsi aux composants de la carte électronique 32 une tension indépendante de la vitesse de rotation de la roue 2, dont la valeur est à la fois suffisante pour leur alimentation et à la fois limitée en amplitude pour ne pas endommager ces composants.

Les premiers moyens d'adaptation 42 comportent un premier convertisseur de type Buck-Boost 50 qui fonctionne en mode « Buck » quand la tension d'alimentation Vali est supérieure au premier seuil de tension prédéterminé, soit 5 volts, et en mode « Boost » quand la tension d'alimentation est inférieure au premier seuil de tension prédéterminé. Le premier convertisseur de type Buck-Boost 50 comprend classiquement un premier condensateur 51, une première inductance 52, un premier transistor constituant un premier interrupteur 53 et une première diode 54. Un capteur de courant 55 est monté en série avec la première inductance 52 et mesure le courant circulant dans la première inductance 52.

Les premiers moyens d'adaptation 42 comportent en outre un circuit de régulation 60 destiné à ajuster une loi de commande de type modulation de largeur d'impulsion pour commander le premier convertisseur de type Buck-Boost 50.

Le circuit de régulation 60 comporte une première boucle de régulation 61 et une deuxième boucle de régulation 62 imbriquées.

La première boucle de régulation 61 comporte un capteur de tension 63, un premier bloc de multiplication 64 par un premier gain K1, un premier soustracteur 65, un générateur de tension 66 délivrant une consigne de tension Cv (égale en l'occurrence au premier seuil de tension prédéterminé, c'est-à-dire à 5 volts), un premier correcteur proportionnel-intégral 67 et un premier saturateur 68.

La deuxième boucle de régulation 62 comporte un deuxième bloc de multiplication 69 par un deuxième gain K2, un deuxième soustracteur 70, un deuxième correcteur proportionnel-intégral 71, un deuxième saturateur 72, un comparateur 73, un générateur de rampe 74 et un pilote 75 du premier interrupteur 53.

Le capteur de tension 63 mesure la tension délivrée par le premier convertisseur de type Buck-Boost 50. La consigne de tension 66 est une valeur de tension représentative du premier seuil de tension prédéterminé. Le premier soustracteur 65 soustrait à la consigne de tension 66 une valeur de tension obtenue par une multiplication de la tension mesurée par le capteur de tension 63 par le premier gain K1. Une erreur en tension Err_v est ainsi obtenue. L'erreur en tension Err_v est corrigée par le premier correcteur proportionnel-intégral 67 et le premier saturateur 68 qui permettent de stabiliser la première boucle de régulation 61 et de minimiser l'erreur statique de la première boucle de régulation 61.

La sortie du premier saturateur 68 est une consigne en courant Ci qui définit le courant requis par le premier convertisseur de type Buck-Boost 50 pour générer une tension égale à la consigne de tension Cv.

Le deuxième soustracteur 70 soustrait à la consigne de courant Ci une valeur de courant obtenue par multiplication du courant mesuré par le capteur de courant 55 par le deuxième gain K2. Une erreur en courant Err_i est ainsi obtenue. L'erreur en courant Err_i est corrigée par le deuxième correcteur proportionnel-intégral 71 et le deuxième saturateur 72 qui permettent de stabiliser la deuxième boucle de régulation 62 et de minimiser l'erreur statique de la deuxième boucle de régulation 62. La sortie du deuxième saturateur 72 est comparée par le comparateur 73 à un signal triangulaire généré par le générateur de rampe 74 à une fréquence ici égale à 20 kilohertz. Le signal ainsi généré est un signal de modulation de largeur d'impulsion qui commande le premier interrupteur 53 via le pilote 75, de sorte que le premier convertisseur Buck-Boost 50 génère une tension proche de la tension de consigne Cv.

Cependant, lorsque la vitesse de rotation de la roue 2 est trop faible, l'énergie associée à la tension de mesure Vmes n'est pas suffisante pour que le premier convertisseur de type Buck-Boost 50 fournisse sous 5 volts un courant suffisant pour alimenter à la fois les composants de la carte électronique 32 et le capteur de température 20.

Pour pallier à ce problème, les moyens de stockage d'énergie 44 sont destinés à stocker une énergie électrique lorsque la vitesse de rotation de la roue 2 est supérieure à un premier seuil de vitesse prédéterminé et à libérer l'énergie électrique stockée pour alimenter la carte électronique 32 et le capteur de température 20 lorsque la vitesse de rotation de la roue 2 est inférieure à un deuxième seuil de vitesse prédéterminé.

Le premier seuil de vitesse prédéterminé et le deuxième seuil de vitesse prédéterminé sont ici tous deux égaux et correspondent à une vitesse de l'aéronef égale à 10 mètres par seconde. On note que les moyens de stockage 44 peuvent être utilisés lorsque l'aéronef est à l'arrêt, pour alimenter le capteur de température 20 du frein 15, recevoir l'information de mesure de la température du frein 15 et la transmettre à l'unité de contrôle 27.

Les moyens de stockage d'énergie 44 comportent un composant de stockage 79, en l'occurrence un supercondensateur, qui requiert pour être chargé l'application à ses bornes d'une tension de stockage Vstock de 2,7 volts.

Les moyens de stockage d'énergie 44 comportent des deuxièmes moyens d'adaptation 80 destinés à abaisser la tension d'alimentation Vali lorsque celle-ci est supérieure à un deuxième seuil de tension prédéterminé pour charger le supercondensateur 79, le deuxième seuil prédéterminé étant en l'occurrence égal à la tension de stockage Vstock du supercondensateur 79, et à relever la tension de stockage Vstock aux bornes du supercondensateur 79 lorsqu'il convient de libérer l'énergie électrique pour alimenter la carte électronique 32 et le capteur de température 20.

Les deuxièmes moyens d'adaptation 80 comportent pour cela un deuxième convertisseur de type Buck-Boost 81 connecté parallèlement au premier convertisseur de type Buck-Boost 50.

Le deuxième convertisseur de type Buck-Boost 81 utilise le premier condensateur 51, la première inductance 52 et la première diode 54, et comporte en outre une deuxième inductance 82.

Les deuxièmes moyens d'adaptation 43 comportent de plus un module de commande 83, un transistor de stockage 84 associé à une deuxième diode 85 formant un deuxième interrupteur 86 et un transistor de décharge 87 associé à une troisième diode 88 formant un troisième interrupteur 89.

Au moment du stockage d'énergie, si la tension d'alimentation Vali est supérieure au deuxième seuil de tension prédéterminé, le module de commande 83 ferme le deuxième interrupteur 86 et ouvre le troisième interrupteur 89. Le deuxième convertisseur de type Buck-Boost 81 abaisse la tension d'alimentation pour charger le supercondensateur 79 en appliquant à ses bornes la tension de stockage Vstock.

Au moment de la libération d'énergie, le module de commande 83 ouvre le deuxième interrupteur 86 et ferme le troisième interrupteur 89. Le deuxième convertisseur de type Buck-Boost 79 relève la tension de stockage Vstock aux bornes du supercondensateur 79 pour générer une tension proche du premier seuil de tension prédéterminé permettant d'alimenter les composants de la carte électronique 32.

Le stockage d'énergie et la libération d'énergie sont commandés en fonction de la vitesse de rotation de la roue 2.

Lorsque la vitesse de rotation de la roue 2 est suffisamment élevée pour générer une tension de mesure Vmes associée à une énergie qui permet à la fois d'alimenter les composants de la carte électronique 32 et de stocker de l'énergie, le stockage d'énergie est commandé.

Lorsque la vitesse de rotation de la roue 2 permet uniquement d'alimenter les composants de la carte électronique 32, les moyens de stockage d'énergie 44 sont désactivés.

Lorsque la vitesse de rotation de la roue 2 ne permet plus d'alimenter les composants de la carte électronique 32, la libération d'énergie est commandée.

L'invention n'est pas limitée aux modes de réalisation particuliers qui viennent d'être décrits, mais, bien au contraire, couvre toute variante entrant dans le cadre de l'invention tel que défini par les revendications.

Bien que l'on ait indiqué que les moyens de traitement sont adaptés à numériser la tension de mesure et à transformer la fréquence de la tension de mesure en une information de vitesse de rotation, les moyens de traitement peuvent être utilisés pour réaliser tout type d'opérations de traitement sur la tension de mesure : acquisition, filtrage, etc. L'amplitude la tension de mesure pourrait aussi être utilisée pour obtenir la vitesse de rotation de la roue.

On a ici indiqué que la carte électronique était aussi utilisée pour alimenter le capteur de température du frein et recevoir une information de température provenant de ce capteur.

On note que, dans le cas où le capteur est une sonde thermocouple, le capteur n'a pas besoin d'être alimenté et la réception des informations consiste uniquement à mesurer une différence de potentiel aux bornes de la sonde thermocouple. Une telle mesure nécessite aussi de mesurer la température de soudure froide, qui peut être réalisée au niveau de la carte électronique si la température à l'intérieur de l'essieu le permet.

On note par ailleurs que la carte électronique peut parfaitement être connectée à un premier équipement externe situé au voisinage de la roue, autre qu'un capteur de température de frein, dans le but d'échanger des données avec le premier équipement externe.

On note aussi que la carte électronique peut parfaitement être connectée à un deuxième équipement externe situé au voisinage de la roue, autre qu'un capteur de température de frein, dans le but d'alimenter le deuxième équipement externe.

Le premier ou le deuxième équipement externe peuvent par exemple être un équipement quelconque comportant un capteur destiné à mesurer un paramètre associé à la roue, tel qu'un capteur de pression destiné à mesurer la pression du pneumatique de la roue, etc.

## Revendications

1. Dispositif de mesure de la vitesse de rotation d'une roue de véhicule, le dispositif de mesure comportant un corps (22) dans lequel sont intégrés :
- un rotor (30) pouvant être entraîné en rotation par la roue et sur lequel est monté au moins un aimant permanent (33) ;
- un stator (31) comportant un bobinage (36) générant une tension de mesure (Vmes) lorsque la roue (2) et donc l'aimant permanent tournent, la tension de mesure étant représentative de la vitesse de rotation de la roue ;
- une carte électronique (32) comportant des moyens de traitement (40) de la tension de mesure ;
- des moyens d'alimentation (41) adaptés à générer à partir de la tension de mesure une tension d'alimentation (Vali) qui dépend de l'amplitude et de la fréquence de la tension de mesure (Vₘₑₛ), destinée à alimenter la carte électronique ;
la carte électronique comportant des premiers moyens d'adaptation (42) destinés à abaisser la tension d'alimentation lorsque celle-ci est supérieure à un premier seuil de tension prédéterminé et à relever la tension d'alimentation lorsque celle-ci est inférieure à un deuxième seuil de tension prédéterminé, fournissant ainsi aux composants de la carte électronique (32) une tension indépendante de la vitesse de rotation de la roue.

2. Dispositif de mesure selon la revendication 1, dans lequel les premiers moyens d'adaptation comportent un premier convertisseur de type Buck-Boost (50).

3. Dispositif de mesure selon la revendication 2, dans lequel les premiers moyens d'adaptation comportent un circuit de régulation (60) destiné à ajuster une loi de commande de type modulation de largeur d'impulsion pour commander le premier convertisseur de type Buck-Boost.

4. Dispositif de mesure selon l'une des revendications précédentes, dans lequel la carte électronique comporte en outre des moyens de stockage d'énergie (44) destinés à stocker une énergie électrique lorsque la vitesse de rotation de la roue est supérieure à un premier seuil de vitesse prédéterminé et à libérer l'énergie électrique stockée pour alimenter la carte électronique lorsque la vitesse de rotation de la roue est inférieure à un deuxième seuil de vitesse prédéterminé.

5. Dispositif de mesure selon la revendication 4, dans lequel les moyens de stockage d'énergie coopèrent avec des deuxièmes moyens d'adaptation (43) destinés à abaisser la tension d'alimentation lorsque celle-ci est supérieure à un troisième seuil de tension prédéterminé pour charger un composant de stockage (79) au moment du stockage de l'énergie électrique, et à relever une tension de stockage aux bornes du composant de stockage au moment où l'énergie électrique est libérée.

6. Dispositif de mesure selon la revendication 5, dans lequel les deuxièmes moyens d'adaptation comportent un deuxième convertisseur de type Buck-Boost (80).

7. Dispositif de mesure selon la revendication 5, dans lequel le composant de stockage (79) est un supercondensateur.

8. Dispositif de mesure selon l'une des revendications précédentes, dans lequel les moyens de traitement (40) sont adaptés à numériser la tension de mesure et/ou à transformer la tension de mesure en une information de vitesse de rotation.

9. Dispositif de mesure selon l'une des revendications précédentes, dans lequel la carte électronique (32) est connectée à un premier équipement externe situé au voisinage de la roue (2) et est adaptée à échanger des données avec le premier équipement externe.

10. Dispositif de mesure selon l'une des revendications précédentes, dans lequel la carte électronique (32) est connectée à un deuxième équipement externe situé au voisinage de la roue (2) et est adaptée à alimenter le deuxième équipement externe.

11. Dispositif de mesure selon l'une des revendications 9 ou 10, dans lequel le premier équipement externe ou le deuxième équipement externe comporte un capteur destiné à mesurer un paramètre associé à la roue.

12. Dispositif de mesure selon l'une des revendications précédentes, dans lequel le rotor (30) est entraîné en rotation par une tige (34) solidaire en rotation d'un capot (11) de la roue (2).

## Patentansprüche

1. Vorrichtung zum Messen der Drehgeschwindigkeit eines Fahrzeugrades, wobei die Messvorrichtung ein Gehäuse (22) umfasst, in dem integriert sind:
- ein Rotor (30), der von dem Rad in Drehung angetrieben werden kann und auf dem mindestens ein Dauermagnet (33) angebracht ist;
- ein Stator (31), der eine Wicklung (36) umfasst, die eine Messspannung (Vmes) erzeugt, wenn sich das Rad (2) und folglich der Dauermagnet drehen, wobei die Messspannung repräsentativ für die Drehgeschwindigkeit des Rades ist;
- eine Leiterplatte (32), die Verarbeitungsmittel (40) zur Verarbeitung der Messspannung umfasst;
- Versorgungsmittel (41), die dazu geeignet sind, anhand der Messspannung eine Versorgungsspannung (Vali) zu erzeugen, die von der Amplitude und der Frequenz der Messspannung (Vₘₑₛ) abhängt und dazu bestimmt ist, die Leiterplatte zu versorgen;
wobei die Leiterplatte erste Anpassungsmittel (42) umfasst, die dazu bestimmt sind, die Versorgungsspannung zu senken, wenn diese größer als ein vorgegebener erster Spannungsschwellwert ist, und die Versorgungsspannung zu erhöhen, wenn diese kleiner als ein vorgegebener zweiter Spannungsschwellwert ist, wobei so den Bauelementen der Leiterplatte (32) eine von der Drehgeschwindigkeit des Rades unabhängige Spannung geliefert wird.

2. Messvorrichtung nach Anspruch 1, bei der die ersten Anpassungsmittel einen ersten Wandler (50) vom Typ Buck-Boost umfassen.

3. Messvorrichtung nach Anspruch 2, bei der die ersten Anpassungsmittel einen Regelkreis (60) umfassen, der dazu bestimmt ist, ein Steuergesetz vom Typ Pulsweitenmodulation anzupassen, um den ersten Wandler vom Typ Buck-Boost zu steuern.

4. Messvorrichtung nach einem der vorhergehenden Ansprüche, bei dem die Leiterplatte ferner Energiespeichermittel (44) umfasst, die dazu bestimmt sind, eine elektrische Energie zu speichern, wenn die Drehgeschwindigkeit des Rades größer als ein vorgegebener erster Geschwindigkeitsschwellwert ist, und gespeicherte elektrische Energie freizusetzen, um die Leiterplatte zu versorgen, wenn die Drehgeschwindigkeit des Rades kleiner als ein vorgegebener zweiter Geschwindigkeitsschwellwert ist.

5. Messvorrichtung nach Anspruch 4, bei der die Energiespeichermittel mit zweiten Anpassungsmitteln (43) zusammenarbeiten, die dazu bestimmt sind, die Versorgungsspannung zu senken, wenn diese größer als ein vorgegebener dritter Spannungsschwellwert ist, um eine Speicherkomponente (79) zum Zeitpunkt der Speicherung der elektrischen Energie zu laden, und eine Speicherspannung an den Klemmen der Speicherkomponente zu dem Zeitpunkt zu erhöhen, zu dem die elektrische Energie freigesetzt wird.

6. Messvorrichtung nach Anspruch 5, bei der die zweiten Anpassungsmittel einen zweiten Wandler (80) vom Typ Buck-Boost umfassen.

7. Messvorrichtung nach Anspruch 5, bei der die Speicherkomponente (79) ein Superkondensator ist.

8. Messvorrichtung nach einem der vorhergehenden Ansprüche, bei dem die Verarbeitungsmittel (40) daran angepasst sind, die Messspannung zu digitalisieren und/oder die Messspannung in eine Drehgeschwindigkeitsinformation umzuwandeln.

9. Messvorrichtung nach einem der vorhergehenden Ansprüche, bei dem die Leiterplatte (32) mit einem ersten externen Gerät verbunden ist, das sich in der Nähe des Rades (2) befindet, und daran angepasst ist, mit dem ersten externen Gerät Daten auszutauschen.

10. Messvorrichtung nach einem der vorhergehenden Ansprüche, bei der die Leiterplatte (32) mit einem zweiten externen Gerät verbunden ist, das sich in der Nähe des Rades (2) befindet, und daran angepasst ist, das zweite externe Gerät zu versorgen.

11. Messvorrichtung nach einem der Ansprüche 9 oder 10, bei der das erste externe Gerät oder das zweite externe Gerät einen Sensor umfasst, der dazu bestimmt ist, einen mit dem Rad verknüpften Parameter zu messen.

12. Messvorrichtung nach einem der vorhergehenden Ansprüche, bei dem der Rotor (30) von einer Stange (34) in Drehung angetrieben wird, die drehfest mit einer Abdeckung (11) des Rades (2) verbunden ist.

## Claims

1. Measurement device for measuring the rotational speed of a vehicle wheel, the measurement device comprising a body (22) incorporating:
- a rotor (30) which can be rotated by the wheel and on which at least one permanent magnet (33) is mounted;
- a stator (31) comprising a winding (36) generating a measurement voltage (Vmes) when the wheel (2) and therefore the permanent magnet turn, the measurement voltage being indicative of the rotational speed of the wheel;
- an electronic board (32) comprising processing means (40) for processing the measurement voltage;
- power supply means (41) designed to generate, from the measurement voltage, a power supply voltage (Vali) intended to power the electronic board;
the electronic board comprising first voltage-matching means (42) intended to drop the power supply voltage when the latter is above a predetermined first voltage threshold and to raise the power supply voltage when the latter is below a predetermined second voltage threshold.

2. Measurement device according to Claim 1, in which the first voltage-matching means comprise a first converter of the Buck-Boost type (50).

3. Measurement device according to Claim 2, in which the first voltage-matching means comprise a control circuit (60) intended to adjust a control law of pulse width modulation type to operate the first converter of Buck-Boost type.

4. Measurement device according to one of the preceding claims, in which the electronic board further comprises energy-storage means (44) intended to store electrical energy when the rotational speed of the wheel is above a predetermined first speed threshold and to release the stored electrical energy to power the electronic board when the rotational speed of the wheel is below a predetermined second speed threshold.

5. Measurement device according to Claim 4, in which the energy-storage means collaborate with second voltage-matching means (43) intended to drop the power supply voltage when the latter is above a predetermined third voltage threshold so as to charge a storage component (79) at the time of storage of the electrical energy, and to raise a storage voltage across the terminals of the storage component at the moment when the electrical energy is released.

6. Measurement device according to Claim 5, in which the second voltage-matching means comprise a second converter of the Buck-Boost type (80).

7. Measurement device according to Claim 5, in which the storage component (79) is a supercapacitor.

8. Measurement device according to one of the preceding claims, in which the processing means (40) are designed to digitize the measurement voltage and/or to convert the measurement voltage into rotational-speed information.

9. Measurement device according to one of the preceding claims, in which the electronic board (32) is connected to a first external equipment item situated near the wheel (2) and is designed to exchange data with the first external equipment item.

10. Measurement device according to one of the preceding claims, in which the electronic board (32) is connected to a second external equipment item situated near the wheel (2) and is designed to power the second external equipment item.

11. Measurement device according to either of Claims 9 and 10, in which the first external equipment item or the second external equipment item comprises a sensor intended to measure a parameter associated with the wheel.

12. Measurement device according to one of the preceding claims, in which the rotor (30) is rotated by a rod (34) that rotates as one with a cap (11) of the wheel (2) .
